Europäisches Patentamt

European Patent Office

Office européen des brevets

(11) Veröffentlichungsnummer: **0 263 534 B1**

# (12) EUROPÄISCHE PATENTSCHRIFT

(45) Veröffentlichungstag der Patentschrift: **07.08.91**

(21) Anmeldenummer: **87115081.9**

(22) Anmeldetag: **24.10.84**

(51) Int. Cl.⁵: **H05K 7/14**

(60) Veröffentlichungsnummer der früheren Anmeldung nach Art. 76 EPÜ: **0 147 560**

(54) **Baugruppenträger.**

(30) Priorität: 08.11.83 DE 3340334
08.11.83 DE 8332022 U

(43) Veröffentlichungstag der Anmeldung:
**13.04.88 Patentblatt 88/15**

(45) Bekanntmachung des Hinweises auf die
Patenterteilung:
**07.08.91 Patentblatt 91/32**

(84) Benannte Vertragsstaaten:
**CH DE FR GB IT LI NL SE**

(56) Entgegenhaltungen:
**DE-A- 2 813 812**
**DE-U- 7 336 813**
**FR-A- 2 399 183**
**US-A- 3 755 630**

(73) Patentinhaber: **Endress u. Hauser GmbH u. Co.**
**Hauptstrasse 1**
**W-7864 Maulburg(DE)**

(72) Erfinder: **Schmidt,Klaus Ing.-grad.**
**Im Grund 6**
**7860 Schopfheim(DE)**
Erfinder: **Hintner, Gottfried, Dipl.-Ing.**
**Talstrasse 24**
**7860 Schopfheim(DE)**

(74) Vertreter: **Leiser, Gottfried, Dipl.-Ing.**
**Patentanwälte Prinz, Leiser, Bunke & Partner**
**Manzingerweg 7**
**W-8000 München 60(DE)**

**Beschreibung**

Die Erfindung betrifft einen Baugruppenträger, der im Innern eines Schutzgehäuses fest montiert ist und an dem Kontaktfederleisten zur Aufnahme von Kontaktstiftleisten an Leiterplatten sowie Anschlußverbinder für aus dem Schutzgehäuse nach außen führende Anschlußkabel befestigt sind, siehe beispielsweise die US-A- 3 755 630.

Unter einem Baugruppenträger versteht man einen in den Maßen genormten Profilrahmen zum Einbau in einen Schaltschrank oder in ein separates Gehäuse. Der Profilrahmen ist durch eine variable genormte Aufteilung für die Aufnahme mehrerer in ihrer Breite ebenfalls genormter, verschiedener Gerätebaueinheiten der elektrischen Signalübertragungstechnik geeignet. Die Gerätebaueinheiten sind ohne eigenes Gehäuse ausgebildet und bestehen im wesentlichen aus einer Frontplatte mit Anzeigegeräten und Bedienungselementen, einer Leiterplatte und einem Anschlußelement in Form eines an der Rückseite angeordneten Steckverbindungsteils. Die Gerätebaueinheiten werden von vorn in den Baugruppenträger eingeschoben, und ihre Steckverbindungsteile (z.B. Stiftleisten) sind in dazu komplementäre Steckverbindungsteile (z.B. Federleisten) einsteckbar, die an der Rückseite des Baugruppenträgers angebracht sind. Die Anschlußelemente (z.B. Lötstifte oder "wire-wrap"-Stifte) der Steckverbindungsteile des Baugruppenträgers sind zum Teil miteinander verbunden, zum Teil durch Verbindungsleiter mit von außen zugänglichen Anschlußverbindern (z.B. Klemmenleisten) verbunden.

Bei der Überwachung oder der Steuerung industrieller Prozesse kann es vorkommen, daß Prozeßparameter mit Hilfe hochempfindlicher elektronischer Gerätebaueinheiten an Orten überwacht oder auch gesteuert werden müssen, an denen für die Gerätebaueinheiten schädliche Umweltbedingungen wie hohe Luftfeuchtigkeit oder staubhaltige Luft vorhanden sind. Insbesondere auch beim Einsatz solcher Überwachungs- und Steuergeräte im Freien muß für einen Schutz der Gerätebaueinheiten vor den schädlichen Umwelteinflüssen gesorgt werden. Zum Schutz der Gerätebaueinheiten werden eigene Schutzgehäuse verwendet, die die Baugruppenträger mit den elektronischen Gerätebaueinheiten hermetisch einschließen, trotzdem aber das Herstellen elektrischer Verbindungen zu den Baugruppenträgern und den darin enthaltenen Gerätebaueinheiten ermöglichen.

Die an ein solches Schutzgehäuse gestellten Anforderungen sind hoch. Es muß ermöglichen, verschiedene Überwachungs- oder Steuergeräte ohne großen Aufwand auch am Einsatzort einzubauen oder die bereits eingebauten Gerätebaueinheiten gegen andere Gerätebaueinheiten je nach den Wünschen des Anwenders auszutauschen und an die nach außen führenden elektrischen Leitungen anzuschließen.

Die Aufgabe der Erfindung besteht daher darin, einen Baugruppenträger mit einem Schutzgehäuse der geschilderten Art so auszugestalten, daß ein bequemes und rasches Anschließen der nach außen führenden elektrischen Leitungen an den jeweils im Schutzgehäuse untergebrachten Baugruppenträger bzw. die darin untergebrachten elektronischen Gerätebaueinheiten möglich ist.

Erfindungsgemäß wird diese Aufgabe dadurch gelöst, daß die Anschlußverbinder an der Unterseite des Baugruppenträgers in wenigstens zwei im Abstand übereinanderliegenden Reihen angeordnet sind, die sich parallel zur Gehäusefrontplatte längs einer von einer Gehäuseseitenwand zur anderen verlaufenden Linie erstrecken, daß die Anschlußverbinder der unteren Reihe gegenüber den Anschlußverbindern der oberen Reihe in Richtung zur Gehäuserückwand nach hinten versetzt sind und daß der Gehäuseboden im Abstand von der untersten Reihe der Anschlußverbinder verläuft und in dem unterhalb der Anschlußverbinder liegenden Bereich mit Kabeldurchführungen für die Anschlußkabel versehen ist.

Somit sind die Anschlußverbinder an dem im Innenraum des Schutzgehäuses fest montierten Baugruppenträger so angeordnet, daß zwischen diesen Anschlußverbindern und dem Gehäuseboden, in dem die Kabeldurchführungen angebracht sind, ein Verdrahtungsraum entsteht, der dem jeweiligen Monteur ein einfaches und bequemes Anschließen der Verbindungsleitungen an die Klemmen der Anschlußverbinder gestattet. Da die Kabeldurchführungen in dem unterhalb der Anschlußverbinder liegenden Bereich im Gehäuseboden angebracht sind, lassen sich die Verbindungsleitungen auf kurzem Weg von den Kabeldurchführungen zu den Anschlußverbindern führen, so daß eine Trennung der einzelnen Leitungen in solche für eigensichere und in solche für nicht eigensichere Stromkreise möglich ist, was in manchen Anwendungsfällen erforderlich ist. Das Anschliessen der Leitungen an die Klemmen in den Anschlußverbindern kann bequem von der Vorderseite des Schutzgehäuses aus vorgenommen werden; die Rückseite des Gehäuses muß also zum Zweck des Anschließens der Leitungen nicht zugänglich sein.

Vorteilhafte Weiterbildungen der Erfindung sind in den Unteransprüchen gekennzeichnet.

Ein Ausführungsbeispiel der Erfindung ist in der Zeichnung dargestellt. In der Zeichnung zeigt:

Fig. 1    eine Seitenansicht des vertikal geschnittenen Schutzgehäuses eines Baugruppenträgers nach der Erfindung und

Fig. 2    eine Draufsicht auf den Teil des Gehäusebodens des Baugruppenträgers von Fig. 1, in dem die Kabeldurchführungen angebracht sind.

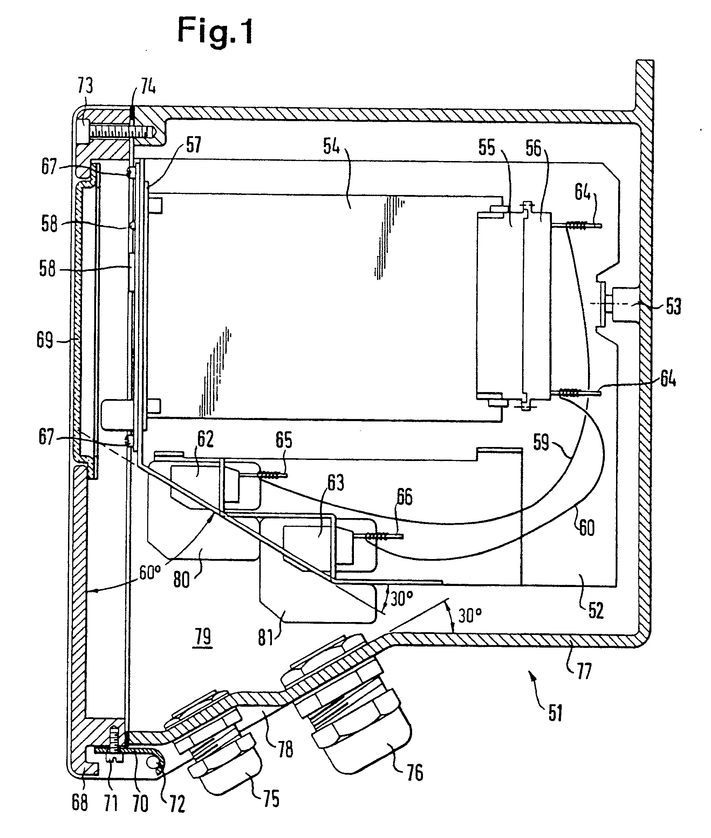

Der in Fig. 1 dargestellte Baugruppenträger 52 ist im Innern eines Schutzgehäuses 51 mittels einer Verschraubung 53 und mittels weiterer in den (in Fig. 1 nicht erkennbaren) Gehäuseseitenwänden angebrachter Verschraubungen fest montiert. Das Schutzgehäuse 51 ist aus Aluminium, beispielsweise im Sandgußverfahren hergestellt.

In den Baugruppenträger 52 sind von vorn, d.h. von der in Fig. 1 links liegenden Seite her, Leiterplatten 54 eingeführt. Jede Leiterplatte 54 ist in nicht dargestellten Führungsschienen gehalten. Am hinteren Ende jeder Leiterplatte 54 ist eine Kontaktstiftleiste 55 angebracht, die in eine Kontaktfederleiste 56 am Baugruppenträger 52 eingesteckt ist. Die Kontaktfederleisten 56 sind mit dem Baugruppenträger 52 verschraubt. An der Vorderseite jeder Leiterplatte 54 ist eine Frontplatte 57 angebracht, in der Meß- oder Anzeigeinstrumente 58 befestigt sind, bei denen es sich um analoge oder digitale Instrumente zum Anzeigen eines Meßwerts oder auch um Leuchtdioden zur Anzeige eines jeweiligen Schaltzustandes der von den Bauelementen auf der Leiterplatte 54 gebildeten elektronischen Gerätebaueinheit handeln kann. Die Meß- oder Anzeigeinstrumente 58 stehen über nicht dargestellte Verbindungen auf der Leiterplatte 54, über die Kontaktstiftleiste 55 und die Kontaktfederleiste 56 sowie über Leitungen 59 und 60 mit Anschlußverbindern 62 und 63, die beispielsweise als Klemmenleisten ausgebildet sind, in Verbindung. Zur Herstellung der Verbindung zwischen den Kontaktfederleisten 56 und den Anschlußverbindern 62 und 63 sind die Leitungen 59, 60 an "Wire-wrap"-Stiften 64 an der Rückseite der Kontaktfederleisten 56 und an ebensolchen "Wire-wrap"-Stiften 65, 66 an der Rückseite der Anschlußverbinder 62 bzw. 63 befestigt.

Die Frontplatten 57 sind mit Hilfe von Schrauben 67 am Baugruppenträger 52 befestigt.

An der Vorderseite des Gehäuses 51 ist eine einen Deckel bildende Gehäusefrontplatte 68 angebracht. In dieser Gehäusefrontplatte 68 ist in Ausrichtung auf den Bereich des Baugruppenträgers 52, der zur Aufnahme der Leiterplatten 54 bestimmt ist, ein Sichtfenster 69 angebracht. Dieses Sichtfenster 69 besteht vorzugsweise aus einem Polycarbonat, und es ist mit der Gehäusefrontplatte 68 verklebt. Die Gehäusefrontplatte 68 weist an ihrer unteren Seite einen Haltehaken 70 auf, der mittels einer Schraube 71 an der Gehäusefrontplatte 68 befestigt ist. Am Gehäuse 51 ist ein Bolzen 72 angebracht, um den ein gekrümmter Abschnitt des Haltehakens 70 gelegt ist. Die Gehäusefrontplatte 68 kann dadurch geöffnet werden, daß eine im Bereich der Oberseite des Gehäuses 51 angebrachte Schraube 73 gelöst wird. Nach Lösen der Schraube 73 kann die Gehäusefrontplatte 68 nach unten geklappt werden, wobei der Bolzen 72 einen Drehpunkt für den Haltehaken 70 bildet. Wegen der Krümmung des Haltehakens 70 kann die Gehäusefrontplatte 68 in der nach unten geklappten Position vollständig vom Rest des Gehäuses abgenommen werden.

Damit das Gehäuse 51 gegen das Eindringen von Feuchtigkeit und von Staub geschützt wird, ist zwischen die Gehäusefrontplatte 68 und den Rest des Gehäuses eine Dichtung 74 eingefügt.

Die in das Gehäuse 51 führenden Anschlußkabel werden durch mehrere Kabeldurchführungen 75, 76 geführt. Diese Kabeldurchführungen sind wasserdicht, so daß auch an dieser Stelle eine hermetische Abdichtung gegen Feuchtigkeit und Staub gewährleistet ist.

Der Gehäuseboden 77 verläuft im Bereich der Kabeldurchführungen 75, 76 in einem Winkel von 30° schräg nach unten zur Unterkante der Gehäusefrontplatte 68. Die Anschlußverbinder 62, 63 sind an der Unterseite des Baugruppenträgers 52 in zwei im Abstand übereinanderliegenden Reihen angeordnet, die sich parallel zur Gehäusefrontplatte 68 längs einer von einer Gehäuseseitenwand zur anderen verlaufenden Linie erstrecken. Die Anschlußverbinder 63 der unteren Reihe sind dabei gegen die Anschlußverbinder 62 der oberen Reihe so in Richtung zur Gehäuserückwand nach hinten versetzt, daß eine gedachte Verbindungslinie zwischen den Reihen mit der Gehäusefrontplatte einen Winkel von 60° bildet. Dies bedeutet auch, daß die gedachte Verbindungslinie der Reihen mit dem horizontal verlaufenden Teil des Gehäusebodens 77 einen Winkel von 30° bildet.

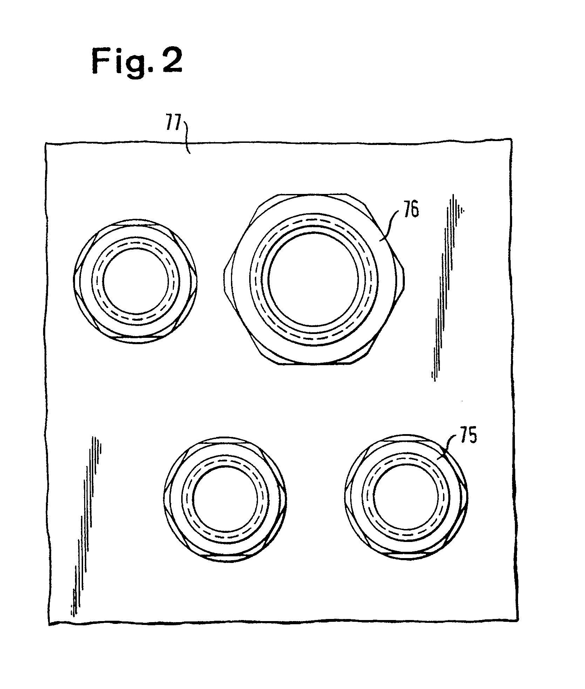

Wie aus Fig. 2 zu erkennen ist, sind für jede Reihe der Anschlußverbinder 62, 63 zwei Kabeldurchführungen in dem schräg nach unten verlaufenden Teil des Gehäusebodens 77 angeordnet. Die Kabeldurchführungen sind ebenfalls in zwei Reihen angeordnet, die im wesentlichen senkrecht unter den Reihen der Anschlußverbinder verlaufen.

Aufgrund der Abwinklung des Gehäusebodens 77 im Bereich der Kabeldurchführungen 75, 76 und der versetzten Anordnung der Reihen der Anschlußverbinder 62, 63 entsteht bei abgenommener oder nach unten geklappter Gehäusefrontplatte 68 ein sich in einem Winkel von 60° nach vorne öffnender Raum 79, so daß genügend Platz ist, damit ein Monteur die durch die Kabeldurchführungen 75 und 76 eingeführten Leitungen an die Klemmen der Anschlußverbinder 62, 63 anschließen kann. Außerdem ist der Raum 79 ausreichend groß, daß zwischen einzelnen Gruppen von Klemmen an den Anschlußverbindern Trennplatten 80, 81 angebracht werden können, mit deren Hilfe die Anschlußverbinder 62, 63 in Bereiche mit eigensicheren Stromkreisen und in Bereiche mit nicht eigensicheren Stromkreisen unterteilt werden können. Der Trennung von eigensicheren Stromkreisen von nicht eigensicheren Stromkreisen dient auch die Maßnahme, die Kabeldurchführungen 75 und 76 gemäß Fig. 2 in den zwei Reihen versetzt anzuordnen. Dadurch können die Leitungen leichter räumlich voneinander getrennt und ohne Überkreuzungen zu den von den Trennplatten 80, 81 abgeteilten Bereichen der Anschlußverbinder 62, 63 geführt werden.

Im Gehäuseboden 77 ist eine zum Gehäuseinneren vorspringende Einbuchtung 78 angebracht, die das Befestigen der Kabeldurchführungen im Gehäuseboden 77 erleichtert.

Das Abwinkeln des Gehäusebodens 77 im Bereich der Gehäusedurchführungen 75 und 76 und die versetzte Anordnung dieser Kabelführungen 75, 76 hat den Vorteil, daß das Einführen der Anschlußkabel und damit die Installation des Schutzgehäuses erheblich erleichtert wird.

**Patentansprüche**

1. Baugruppenträger, der im Innern eines Schutzgehäuses (51) fest montiert ist und an dem Kontaktfederleisten (56) zur Aufnahme von Kontaktstiftleisten (55) an Leiterplatten (54) sowie Anschlußverbinder (62, 63) für aus dem Schutzgehäuse (51) nach außen führende Anschlußkabel befestigt sind, dadurch gekennzeichnet, daß die Anschlußverbinder (62, 63) an der Unterseite des Baugruppenträgers (52) in wenigstens zwei im Abstand übereinanderliegenden Reihen angeordnet sind, die sich parallel zur Gehäusefrontplatte (68) längs einer von einer Gehäuseseitenwand zur anderen verlaufenden Linie erstrecken, daß die Anschlußverbinder (63) jeder Reihe gegenüber den Anschlußverbindern (z.B. 62) der darüberliegenden Reihe in Richtung zur Gehäuserückwand nach hinten versetzt sind und daß der Gehäuseboden (77) im Abstand von der untersten Reihe der Anschlußverbinder (63) verläuft und in dem unterhalb der Anschlußverbinder (62, 63) liegenden Bereich mit Kabeldurchführungen (75, 76) für die Anschlußkabel versehen ist.

2. Baugruppenträger nach Anspruch 1, dadurch gekennzeichnet, daß die Anschlußverbinder (62) der obersten Reihe nahe der Gehäusefrontplatte (68) an der Unterseite des Baugruppenträgers (52) befestigt sind.

3. Baugruppenträger nach Anspruch 2, dadurch gekennzeichnet, daß die Reihen der Anschlußverbinder (62, 63) derart gegeneinander versetzt sind, daß die Verbindungslinie zwischen den Reihen mit der Gehäusefrontplatte (68) einen Winkel von etwa 60° bildet.

4. Baugruppenträger nach einem der Ansprüche 1 bis 3, dadurch gekennzeichnet, daß der Gehäuseboden (77) in dem Bereich, in dem die Kabeldurchführungen (75, 76) angebracht sind, im Winkel bezüglich des Rests des Bodens schräg nach unten zur Gehäusefrontplatte (68) hin verläuft.

5. Baugruppenträger nach Anspruch 4, dadurch gekennzeichnet, daß der Winkel, den der Gehäuseboden (77) in dem Bereich, in dem die Kabeldurchführungen (75, 76) angebracht sind, mit dem Rest des Bodens bildet, etwa 30° beträgt.

6. Baugruppenträger nach Anspruch 5, dadurch gekennzeichnet, daß in dem schräg nach unten verlaufenden Teil des Gehäusebodens (77) im wesentlichen senkrecht unterhalb jeder Reihe von Anschlußverbindern (62, 63) wenigstens eine Kabeldurchführung (75, 76) angebracht ist.

7. Baugruppenträger nach Anspruch 6, dadurch gekennzeichnet, daß für jede Reihe von Anschlußverbindern (62, 63) wenigstens zwei Kabeldurchführungen (75, 76) im schräg nach unten verlaufenden Teil des Gehäusebodens (77) angebracht sind und daß die einer Reihe von Anschlußverbindern (z.B. 62) zugeordneten Kabeldurchführungen (75) in seitlicher Richtung bezüglich der jeder benachbarten Reihe von Anschlußverbindern (z.B. 63) zugeordneten Kabeldurchführungen (76) versetzt sind.

8. Baugruppenträger nach Anspruch 7, dadurch gekennzeichnet, daß die der obersten Reihe von Anschlußverbindern (62) zugeordneten Kabeldurchführungen (75) in einer zum Gehäuseinneren vorspringenden Einbuchtung (78) in dem schräg nach unten zur Gehäusefrontplatte (68) hin verlaufenden Teil des Gehäusebodens (77) angebracht sind.

9. Baugruppenträger nach einem der Ansprüche 1 bis 8, dadurch gekennzeichnet, daß in der Gehäusefrontplatte (68) in Ausrichtung auf den Bereich des Baugruppenträgers (52), der zur Aufnahme der Leiterplatten (54) bestimmt ist, ein Sichtfenster (69) angebracht ist.

10. Baugruppenträger nach einem der Ansprüche 1 bis 9, dadurch gekennzeichnet, daß die Gehäusefrontplatte (68) lösbar mit dem Rest des Gehäuses (51) verbunden ist.

## Claims

1. Assembly support which is fixedly mounted in the interior of a protective housing (51) and on which multipoint female connectors (56) are mounted for receiving contact pin strips (55) on printed-circuit boards (54) and terminal connectors (62, 63) for lead cables leading from the protective housing (51) to the outside, characterized in that the terminal connectors (62, 63) are arranged at the lower side of the assembly support (52) in at least two rows which lie above each other in spaced relationship and which extend parallel to the housing front plate (68) along a line extending from one housing side wall to the other, that the terminal connectors (63) of each row are offset rearwardly in the direction towards the housing rear wall with respect to the terminal connectors (e.g. 62) of the upper row and that the housing bottom (77) extends spaced from the lowermost row of the terminal connectors (63) and is provided in the region lying beneath the terminal connectors (62, 63) with cable bushings (75, 76) for the lead cables.

2. Assembly support according to claim 1, characterized in that the terminal connectors (62) of the uppermost row are mounted near the housing front plate (68) on the lower side of the assembly support (52).

3. Assembly support according to claim 2, characterized in that the rows of the terminal connectors (62, 63) are offset with respect to each other in such a manner that the connecting line between the rows forms an angle of about 60° with the housing front plate (68).

4. Assembly support according to any one of claims 1 to 3, characterized in that in the region in which the cable bushings (75, 76) are disposed the housing bottom (77) extends at an angle to the rest of the bottom inclined downwardly towards the housing front plate (68).

5. Assembly support according to claim 4, characterized in that the angle which the housing bottom (77) in the region in which the cable bushings (75, 76) are disposed makes with the rest of the bottom is about 30°.

6. Assembly support according to claim 5, characterized in that in the inclined downwardly extending portion of the housing bottom (77) substantially vertically beneath each row of terminal connectors (62, 63) at least one cable bushing (75, 76) is disposed.

7. Assembly support according to claim 6, characterized in that for each row of terminal connectors (62, 63) at least two cable bushings (75, 76) are formed in the downwardly extending portion of the housing bottom (77) and that the cable bushings (75) associated with one row of terminal connectors (e.g. 62) are offset in the lateral direction with respect to the cable bushings (76) associated with each adjacent row of terminal connectors (e.g. 63).

8. Assembly support according to claim 7, characterized in that the cable bushings (75) associated with the uppermost row of terminal connectors (62) are arranged in a depression (78) projecting towards the housing interior in the portion of the housing bottom (77) extending inclined downwardly towards the housing front plate (68).

9. Assembly support according to any one of claims 1 to 8, characterized in that an inspection window (69) in alignment with the region of the assembly support (52) intended for reception of the printed-circuit boards (54) is formed in the housing front plate (68).

10. Assembly support according to any one of claims 1 to 9, characterized in that the housing front plate (68) is detachably connected to the rest of the housing (51).

## Revendications

1. Châssis de support d'appareillages électriques qui est monté de manière fixe à l'intérieur d'un boîtier de protection (51), et auquel sont fixés d'une part des connecteurs multipolaires à ressorts de contact (56) destinés à recevoir des connecteurs multipolaires à broches de contact (55) situés sur des cartes de circuits imprimés (54), et d'autre part des connecteurs de raccordement (62, 63) destinés à des câbles de raccordement sortant du boîtier de protection (51), caractérisé en ce que les connecteurs de raccordement (62, 63) sont disposés sur le côté inférieur du châssis de support d'appareillages électriques (52) selon au moins deux rangées espacées et superposées, qui s'étendent parallèlement à la plaque frontale de boîtier (68) le long d'une ligne allant d'une paroi latérale du boîtier à l'autre, en ce que les connecteurs de raccordement (63) de chaque rangée sont décalés vers l'arrière en direction de la paroi arrière du boîtier, par rapport aux connecteurs de raccordement (par exemple 62) de la rangée située au-dessus, et en ce que le fond de boîtier (77) s'étend à distance de la rangée inférieure de connecteurs de raccordement (63) et est pourvu de traversées de câbles (75, 76) pour les câbles de raccordement, dans la zone située en-dessous des connecteurs de raccordement (62, 63).

2. Châssis de support d'appareillages électriques selon la revendication 1, caractérisé en ce que les connecteurs de raccordement (62) de la rangée supérieure sont fixés à proximité de la plaque frontale de boîtier (68), sur le côté inférieur du châssis de support d' appareillages électriques (52).

3. Châssis de support d'appareillages électriques selon la revendication 2, caractérisé en ce que les rangées des connecteurs de raccordement (62, 63) sont décalées entre-elles de telle sorte que la ligne de liaison entre les rangées forme un angle d'environ 60° avec la plaque frontale de boîtier (68).

4. Châssis de support d'appareillages électriques selon l'une des revendications 1 à 3, caractérisé en ce que dans la zone dans laquelle sont montées les traversées de câbles (75, 76), le fond de boîtier (77) est coudé par rapport au restant du fond, de manière à s'étendre obliquement vers le bas en direction de la plaque frontale de boîtier (68).

5. Châssis de support d'appareillages électriques selon la revendication 4, caractérisé en ce que l'angle que forme le fond de boîtier (77) dans la zone dans laquelle sont montées les traversées de câbles (75, 76) avec le restant du fond, est d'environ 30°.

6. Châssis de support d'appareillages électriques selon la revendication 5, caractérisé en ce que dans la partie du fond de boîtier (77) s'étendant obliquement vers le bas est montée au moins une traversée de câbles (75, 76) sensiblement à la verticale sous chacune des rangées de connecteurs de raccordement (62, 63).

7. Châssis de support d'appareillages électriques selon la revendication 6, caractérisé en ce que pour chacune des rangées de connecteurs de raccordement (62, 63), il y a au moins deux traversées de câbles (75, 76) montées dans la partie du fond de boîtier (77) s'étendant obliquement vers le bas, et en de que les traversées de câbles (75) associées à l'une des rangées de connecteurs de raccordement (par exemple 62) sont décalées latéralement par rapport aux traversées de câbles (76) associées à chaque rangée voisine de connecteurs de raccordement (par exemple 63).

8. Châssis de support d'appareillages électriques selon la revendication 7, caractérisé en ce que les traversées de câbles (75) associées à la rangée supérieure de connecteurs de raccordement (62) sont montées dans un renfoncement (78) saillant vers l'intérieur du boîtier, dans la partie du fond de boîtier (77) s'étendant obliquement vers le bas en direction de la plaque frontale de boîtier (68).

9. Châssis de support d'appareillages électriques selon l'une des revendications 1 à 8, caractérisé en ce que dans la plaque frontale de boîtier (68) est prévue une fenêtre de visualisation (69) dirigée vers la zone du châssis de support d'appareillages électriques (52) destinée à recevoir les cartes de circuits imprimés 54.

10. Châssis de support d'appareillages électriques selon l'une des revendications 1 à 9, caractérisé en ce que la plaque frontale de boîtier (68) est liée de manière amovible au restant du boîtier (51).

# Fig.1

# Fig. 2